# EUROPEAN PATENT APPLICATION

(11) **EP 4 844 097 A1**
(43) Date of publication of application: **25.11.2026**
(21) Application number: 24928119.7
(22) Date of filing: 28.10.2024
(51) Int. Cl.: C23C 14/22, C23C 14/56, C23C 16/455, C23C 16/54

(54) **VACUUM CHAMBER**

(30) Priority: 08.03.2024 CN 202410265760; 08.03.2024 CN 202420448868 U
(71) Applicant: Suzhou Maxwell Technologies Co., Ltd., Suzhou, Jiangsu 215200 (CN); Suzhou Maizheng Technology Co. Ltd, Suzhou, Jiangsu 215200 (CN)
(72) Inventor: ZHOU, Jian, Suzhou, Jiangsu 215200 (CN); JIANG, Jianxin, Suzhou, Jiangsu 215200 (CN); LIU, Huan, Suzhou, Jiangsu 215200 (CN); CHEN, Chen, Suzhou, Jiangsu 215200 (CN); LIU, Yanan, Suzhou, Jiangsu 215200 (CN); LI, Zhiren, Suzhou, Jiangsu 215200 (CN); LI, Chang, Suzhou, Jiangsu 215200 (CN)
(74) Representative: Balder IP Law, S.L.
(86) International application number: PCT/CN2024/127722
(87) International publication number: WO 2025/185189

(57) **Abstract**

A vacuum chamber comprises a chamber body (1) and a chamber cover (2) disposed on the chamber body (1). The vacuum chamber further comprises at least one first vacuum breaking mechanism (3) and/or at least one second vacuum breaking mechanism (4).The first vacuum breaking mechanism (3) is disposed on the chamber cover (2) and is in communication with a first gas inlet (21) defined in the chamber cover (2). The first vacuum breaking mechanism (3) comprises a first gas inlet plate (31) and a second gas inlet plate (32). A plurality of first gas inlet holes (311) arranged at intervals in the first gas inlet plate (31) are staggered relative to a plurality of second gas inlet holes (321) arranged at intervals in the second gas inlet plate (32) horizontally. The second vacuum breaking mechanism (4) is disposed on an inner side of a bottom wall of the chamber body (1) and is in communication with a second gas inlet (15) defined in the chamber body (1). The second vacuum breaking mechanism (4) comprises a third gas inlet plate (41) and a fourth gas inlet plate (42). A plurality of third gas inlet holes (411) arranged at intervals in the third gas inlet plate (41) are staggered relative to a plurality of fourth gas inlet holes (421) arranged at intervals in the fourth gas inlet plate (42) in the horizontal direction.

## Description

This application claims priority to Chinese Patent Application No. 202410265760.9, filed with the China National Intellectual Property Administration on March 8, 2024, and claims priority to Chinese Patent Application No. 202420448868.7, filed with the China National Intellectual Property Administration on March 8, 2024. The entire contents of the above applications are incorporated herein by reference

### TECHNICAL FIELD

The present application relates to the technical field of vacuum deposition, and particularly relates to a vacuum chamber.

### BACKGROUND

When a vacuum deposition apparatus performs film deposition on substrates such as silicon wafers and glass substrates inside a chamber, the chamber is required to provide a vacuum environment for the substrates. In the related art, substrates to be coated are transferred into and out of the chamber through a load lock chamber and an unload lock chamber. Therefore, the load lock chamber and the unload lock chamber need to be cyclically switched between a vacuum environment and a standard atmospheric state, so that the substrates to be coated can be transferred into the load lock chamber and transferred out of the unload lock chamber. Before substrates to be coated are introduced into the vacuum deposition apparatus, the load lock chamber is vented to convert the vacuum environment within the load lock chamber into a standard atmospheric state, so that the substrates to be coated are transferred into the load lock chamber. Subsequently, the load lock chamber is subjected to an evacuation operation, and the substrates to be coated are transferred into the process chamber for film deposition. In addition, when the substrates have completed the film deposition process and are transferred to the out of the vacuum deposition apparatus via the unload lock chamber, the unload lock chamber needs to be vented to convert the vacuum environment within the unload lock chamber into a standard atmospheric state, thereby allowing the coated substrates to be transferred out of the chamber. Subsequently, the unload lock chamber is subjected to an evacuation operation, and the above process is cyclically repeated to realize continuous production. However, when the chamber is vented by a vacuum breaking mechanism, the load lock chamber and the unload lock chamber are highly sensitive to gas flow in a vacuum environment. If the flow velocity or impact force of the gas flow is excessive, dust inside the chambers is likely to be stirred up, thereby contaminating the substrates and the carriers for holding the substrates. In particular, when the unload lock chamber is vented, the gas flow directly contacts the surfaces of the carriers and the substrates, which is likely to generate pinhole marks on substrate surfaces or even lead to breakage of the substrates, thereby degrading production quality.

With the advancement of technology, shunt assemblies are adopted in the related art to divert incoming gas flow. However, a plurality of shunt channels need to be formed in the shunt assembly, which complicates its overall structure thereof and significantly increases the difficulty of processing and manufacturing.

### SUMMARY

The present application provides a vacuum chamber, which can reduce gas flow velocity during venting and mitigate the impact of gas flow on the interior of the vacuum chamber. Furthermore, the vacuum chamber has a simple structure and is convenient for processing and manufacturing.

The present application provides a vacuum chamber, comprising:
a chamber body;
a chamber cover, wherein the chamber cover is disposed on the chamber body, and a first gas inlet is formed in the chamber cover;
At least one first vacuum breaking mechanism disposed on the chamber cover, wherein the first vacuum breaking mechanism is in communication with the first gas inlet and comprises a first gas inlet plate and a second gas inlet plate; a plurality of first gas inlet holes are arranged at intervals in the first gas inlet plate, and a plurality of second gas inlet holes are arranged at intervals in the second gas inlet plate; and the second gas inlet holes are staggered relative to the first gas inlet holes horizontally.
and/or,
a second gas inlet is formed in the chamber body, and the vacuum chamber further comprises at least one second vacuum breaking mechanism disposed on an inner side of a bottom wall of the chamber body. The second vacuum breaking mechanism is in communication with the second gas inlet and comprises a third gas inlet plate and a fourth gas inlet plate; a plurality of third gas inlet holes are arranged at intervals in the third gas inlet plate, and a plurality of fourth gas inlet holes are arranged at intervals in the fourth gas inlet plate; and the third gas inlet holes are staggered relative to the fourth gas inlet holes in the horizontal direction.

In some embodiments, the first vacuum breaking mechanism further comprises:
a first mounting enclosure disposed on the chamber cover, wherein the first gas inlet plate and the second gas inlet plate are both connected to the first mounting enclosure; the first gas inlet plate, the first mounting enclosure, and the chamber cover jointly define a first gas inlet space; and the first gas inlet plate, the second gas inlet plate, and the first mounting enclosure jointly define a second gas inlet space; and the first gas inlet, the first gas inlet space, and the second gas inlet space are sequentially in communication.

In some embodiments, the second vacuum breaking mechanism further comprises:
a second mounting enclosure disposed on the bottom wall of the chamber body, wherein the third gas inlet plate and the fourth gas inlet plate are both connected to the second mounting enclosure; the third gas inlet plate, the second mounting enclosure, and the bottom wall jointly define a third gas inlet space, and the third gas inlet plate, the fourth gas inlet plate, and the second mounting enclosure jointly define a fourth gas inlet space; and the second gas inlet, the third gas inlet space, and the fourth gas inlet space are sequentially in communication.

In some embodiments, the second vacuum breaking mechanism further comprises a second mounting enclosure, a gas inlet passage, and a venting back plate. A first end of the gas inlet passage is connected to the second gas inlet, and a second end of the gas inlet passage is connected to the venting back plate. The third gas inlet plate, the fourth gas inlet plate, and the venting back plate are all connected to the second mounting enclosure; the third gas inlet plate, the second mounting enclosure, and the venting back plate jointly define a third gas inlet space, and the third gas inlet plate, the fourth gas inlet plate, and the second mounting enclosure jointly define a fourth gas inlet space; and the second gas inlet, the gas inlet passage, the third gas inlet space, and the fourth gas inlet space are sequentially in communication.

In some embodiments, a vacuum pumping port is formed in the bottom wall, and the vacuum chamber is provided with a plurality of second vacuum breaking mechanisms spaced apart from one another; a first vacuum pumping channel is defined between two adjacent second vacuum breaking mechanisms; and the first vacuum pumping channel is in communication with the vacuum pumping port.

In some embodiments, the vacuum chamber comprises four second vacuum breaking mechanisms arranged at intervals. A cross-shaped first vacuum pumping channel is defined among the four second vacuum breaking mechanisms; a second vacuum pumping channel in communication with the first vacuum pumping channel is defined between the outer peripheral wall of each second vacuum breaking mechanism and the side wall of the chamber body; and a central intersection region of the first vacuum pumping channel is directly aligned with the vacuum pumping port located at the center of the bottom wall.

In some embodiments, the height of the cross-shaped first vacuum pumping channel ranges from 30 mm to 200 mm.

In some embodiments, the first vacuum breaking mechanism further comprises first locking connectors, and the first locking connectors are configured to detachably connect the first gas inlet plate and the second gas inlet plate to the first mounting enclosure.

In some embodiments, the first mounting enclosure and the second gas inlet plate are formed integrally.

In some embodiments, the second vacuum breaking mechanism further comprises second locking connectors, and the second locking connectors are configured to detachably connect the third gas inlet plate and the fourth gas inlet plate to the second mounting enclosure.

In some embodiments, the second mounting enclosure and the fourth gas inlet plate are formed integrally.

In some embodiments, the first vacuum breaking mechanism further comprises first support connecting members extending between the first gas inlet plate and the second gas inlet plate to provide support.
and/or,

In some embodiments, the second vacuum breaking mechanism further comprises second support connecting members extending between the third gas inlet plate and the fourth gas inlet plate to provide support.

In some embodiments, the first gas inlet holes and the third gas inlet holes are straight holes or flared holes; and the second gas inlet holes and the fourth gas inlet holes are straight holes or flared holes.

In some embodiments, the first gas inlet hole and the third gas inlet hole are circular holes, and the second gas inlet hole and the fourth gas inlet hole are elongated holes.

In some embodiments, the number of the first vacuum breaking mechanisms is one and the number of the second vacuum breaking mechanism is four.

In some embodiments, the number of the first vacuum breaking mechanisms is four and the number of the second vacuum breaking mechanisms is four.

### BRIEF DESCRIPTION OF THE DRAWINGS

FIG. 1 is a structural cross-sectional view of a vacuum chamber according to Embodiment 1 of the present application;
FIG. 2 is a bottom view of a first vacuum breaking mechanism according to Embodiment 1 of the present application;
FIG. 3 is a structural cross-sectional view of a first vacuum breaking mechanism according to Embodiment 1 of the present application;
FIG. 4 is an exploded structural view of a first vacuum breaking mechanism according to Embodiment 1 of the present application;
FIG. 5 is a structural cross-sectional view of a second vacuum breaking mechanism according to Embodiment 1 of the present application;
FIG. 6 is a top view of a chamber body according to Embodiment 1 of the present application;
FIG. 7 is a bottom view of a chamber cover according to Embodiment 1 of the present application;
FIG. 8 is a structural cross-sectional view of a vacuum chamber according to Embodiment 2 of the present application;
FIG. 9 is a structural cross-sectional view of a vacuum chamber according to Embodiment 2 of the present application;
FIG. 10 is a structural cross-sectional view of a second vacuum breaking mechanism according to Embodiment 2 of the present application;
FIG. 11 is a structural cross-sectional view of a first vacuum breaking mechanism according to Embodiment 3 of the present application;
FIG. 12 is a structural cross-sectional view of a second vacuum breaking mechanism according to Embodiment 3 of the present application.

### Reference Numerals:

1-chamber body; 11-vacuum pumping port; 12-first vacuum pumping channel;13-bottom wall; 14-side wall; 15-second gas inlet passage; 16-second vacuum pumping channel;
2-chamber cover; 21-first gas inlet;
3-first vacuum breaking mechanism; 31-first gas inlet plate; 311-first gas inlet hole; 32-second gas inlet plate; 321-second gas inlet hole; 33-first mounting enclosure; 34-first locking connector; 35-first support connecting member; 36-first gas inlet space; 37-second gas inlet space;
4-second vacuum breaking mechanism; 41-third gas inlet plate; 411-third gas inlet hole; 42-fourth gas inlet plate; 421-fourth gas inlet hole; 43-second mounting enclosure; 44-gas inlet passage; 45-venting back plate; 46-third gas inlet space; 47-fourth gas inlet space; 48-second locking connector; 49-second support connecting member;
5-vacuum pumping mechanism.

### DETAILED DESCRIPTION OF THE EMBODIMENTS

In the description of the present application, unless otherwise explicitly specified or limited, the terms "connected", "coupled", and "fixed" shall be interpreted in a broad sense. For example, the connection may be a fixed connection, a detachable connection, or an integral structure; may be a mechanical connection or an electrical connection; may be a direct connection or an indirect connection through an intermediate medium; and may also refer to internal communication between two components or an interaction relationship between two components. Those of ordinary skill in the art may understand the specific meanings of the above terms in the present application in light of actual situations.

In the present application, unless otherwise expressly specified, a first feature being "on" or "under" a second feature may include direct contact between the first feature and the second feature, or may include contact between the first feature and the second feature through another intermediate feature therebetween, without direct contact between the first feature and the second feature. Furthermore, references to a first feature being "above", "over", or "on" a second feature encompass configurations in which the first feature is directly above or obliquely above the second feature, or simply mean that the first feature has a greater horizontal height than the second feature. References to a first feature being "below", "under", or "beneath" a second feature encompass configurations in which the first feature is located directly below or obliquely below the second feature, or merely indicate that the vertical height of the first feature is smaller than that of the second feature.

In the description of the present embodiment, orientation or positional relationships defined by terms such as "upper", "lower", "left", and "right" are based on those shown in the drawings. Such terms are merely adopted to facilitate and simplify description, and do not denote or imply that the apparatus or component referred to must have a specific orientation, or be constructed and operated in a specific orientation. In addition, the terms "first" and "second" are merely used for distinguishing different parts in the description and have no special limiting meaning.

### Embodiment 1

When a vacuum deposition apparatus performs film deposition on substrates such as silicon wafers and glass substrates inside a chamber, the chamber is required to provide a vacuum processing environment for the substrates. After the film deposition process on the substrates is completed, the chamber shall be vented to convert the vacuum condition within the chamber to standard atmospheric pressure, so that the coated substrates can be conveyed out of the chamber and the subsequent uncoated substrate is conveyed into the chamber, so as to realize continuous production. In the related art, during venting of the chamber by a vacuum breaking mechanism, the carrier plates within the chamber and the substrates carried by the carrier plates are highly sensitive to gas flow in a vacuum environment. When the gas flow has an excessively high velocity or impact force, pinhole marks are likely to be formed on the surfaces of the carrier plates and the substrates, and may even lead to breakage of the substrates, thereby degrading production quality. With the advancement of technology, shunt assemblies are arranged in the related art to shunt incoming gas flow. However, multiple shunt passages have to be formed in the shunt assembly, which results in a relatively complex structure of the shunt assembly and greatly raises the difficulty of processing and manufacturing.

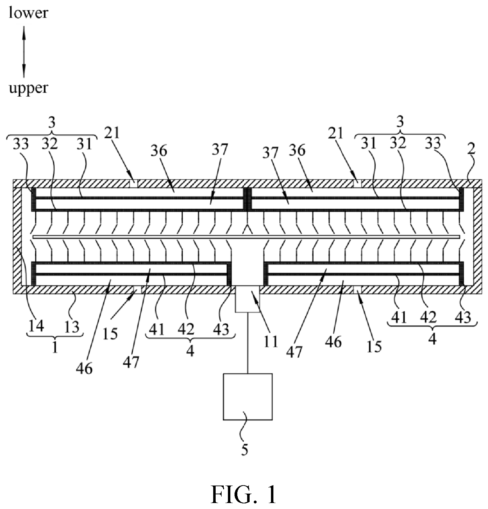

As shown in FIGS. 1 to 5, the present embodiment provides a vacuum chamber, which is a load lock chamber or an unload lock chamber. The vacuum chamber comprises a chamber body 1, a chamber cover 2, at least one first vacuum breaking mechanism 3, and at least one second vacuum breaking mechanism 4. The chamber cover 2 is disposed on the chamber body 1, and a first gas inlet 21 is formed through the chamber cover 2. The first vacuum breaking mechanism 3 is disposed on the chamber cover 2 and is in communication with the first gas inlet 21, wherein the first vacuum breaking mechanism 3 comprises a first gas inlet plate 31 and a second gas inlet plate 32. The first gas inlet plate 31 is formed with a plurality of spaced apart first gas inlet holes 311, and the second gas inlet plate 32 is formed with a plurality of spaced apart second gas inlet holes 321. The second gas inlet holes 321 are staggered relative to the first gas inlet holes 311 horizontally. The chamber body 1 is formed with a second gas inlet 15. The second vacuum breaking mechanism 4 is disposed on the inner side of the bottom wall 13 of the chamber body 1 and is in communication with the second gas inlet 15. The second vacuum breaking mechanism 4 comprises a third gas inlet plate 41 and a fourth gas inlet plate 42. The third gas inlet plate 41 is formed with a plurality of spaced apart third gas inlet holes 411, and the fourth gas inlet plate 42 is formed with a plurality of spaced apart fourth gas inlet holes 421. The third gas inlet holes 411 are staggered relative to the fourth gas inlet holes 421 in the horizontal direction.

The vacuum chamber provided in this embodiment as follows, when venting is carried out via the first vacuum breaking mechanism 3, gas flow flows into the first vacuum breaking mechanism 3 through the first gas inlet 21 formed in the chamber cover 2. Within the first vacuum breaking mechanism 3, the gas flow first passes through the first gas inlet holes 311 of the first gas inlet plate 31. Gas flow exiting each of the first gas inlet holes 311 is blocked by the second gas inlet plate 32, and then flows into the chamber body 1 via each of the second gas inlet holes 321 of the second gas inlet plate 32. The above process forces the gas flow to generate transverse deflection flow, thereby effectively reducing gas flow velocity and the impact force exerted by the gas flow on the interior of the vacuum chamber. Accordingly, the adverse effect of upper gas flow on the carrier plates and substrates inside the chamber is mitigated, and production quality is ensured. When the vacuum chamber is vented via the second vacuum breaking mechanism 4, gas flow flows into the second vacuum breaking mechanism 4 through the second gas inlet 15 formed in the chamber body 1. Within the second vacuum breaking mechanism 4, the gas flow first passes through each of the third gas inlet holes 411 of the third gas inlet plate 41. Gas flow exiting the third gas inlet holes 411 is blocked by the fourth gas inlet plate 42 and then flows into the chamber body 1 via each of the fourth gas inlet holes 421 of the fourth gas inlet plate 42. The above process forces the gas flow to undergo transverse deflection, thereby effectively reducing gas flow velocity and the impact force exerted by the gas flow on the interior of the vacuum chamber. Accordingly, the adverse effect of lower gas flow on the carrier plates and substrates inside the chamber is mitigated, and production quality is ensured. Furthermore, the structural design of the above-described first vacuum breaking mechanism 3 and second vacuum breaking mechanism 4 only requires that the gas inlet holes of the two gas inlet plates of each vacuum breaking mechanism be horizontally staggered, thereby providing a simple structure and greatly facilitating processing and manufacturing.

In this embodiment, the second gas inlet 15 is formed on the bottom wall 13 of the chamber body 1. The first vacuum breaking mechanism 3 and the second vacuum breaking mechanism 4 are vertically spaced apart and configured to perform venting operations on the vacuum chamber from the top and bottom thereof, respectively, thereby effectively improving the vacuum breaking efficiency of the vacuum chamber. In other embodiments, only the first vacuum breaking mechanism 3 may be mounted on the chamber cover 2 to perform vacuum breaking operations on the vacuum chamber; alternatively, only the second vacuum breaking mechanism 4 may be mounted on the inner side of the bottom wall 13 to perform vacuum breaking operations on the vacuum chamber. Furthermore, after the venting operation of the vacuum chamber is completed, when it is required to convert the atmospheric environment inside the vacuum chamber into a vacuum environment, the valves of the gas inlet pipelines in communication with the first gas inlet 21 and the second gas inlet 15 may simply be closed.

In this embodiment, the first gas inlet plate 31 and the second gas inlet plate 32 are spaced apart in the vertical direction (i.e., the up-down direction), and the first gas inlet plate 31 is disposed above the second gas inlet plate 32. In addition, in this embodiment, the third gas inlet plate 41 and the fourth gas inlet plate 42 are also spaced apart in the up-down direction (i.e., the vertical direction), and the fourth gas inlet plate 42 is disposed above the third gas inlet plate 41.

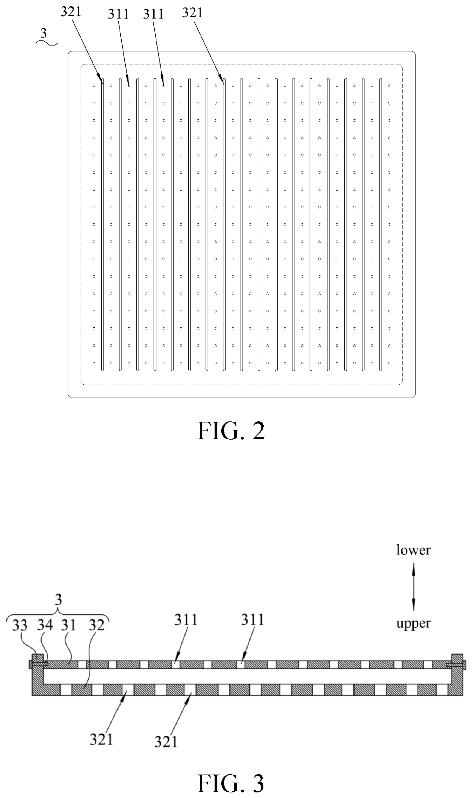

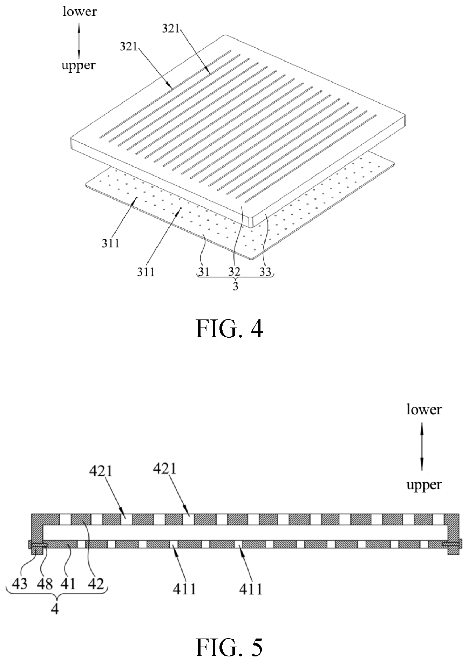

In this embodiment, as shown in FIGS. 2 and 4, the first gas inlet hole 311 is a circular hole and the second gas inlet hole 321 is an elongated hole. By designing the first gas inlet hole 311 as a circular hole and the second gas inlet hole 321 as an elongated hole, the blocking effect of the second gas inlet plate 32 on the gas flow flowing out of the first gas inlet hole 311 is improved, which ensures that the gas flow discharged through the second gas inlet hole 321 can generate transversely deflected flow and also makes the flow velocity of the gas flow discharged through each of the second gas inlet holes 321 more uniform. Optionally, in this embodiment, both the first gas inlet plate 31 and the second gas inlet plate 32 are in the form of rectangular plates. The extending direction of one side of the first gas inlet plate 31 is defined as the first side direction, and the extending direction of another side perpendicular thereto is defined as the second side direction, and the first side and the second side are perpendicular to each other. Wherein, the second gas inlet holes 321 extend along the first side direction, and a plurality of the second gas inlet holes 321 are spaced apart along the second side direction. A plurality of the first gas inlet holes 311 are arranged in an array on the first gas inlet plate 31; moreover, multiple first gas inlet holes 311 spaced apart along the first side direction form one first gas inlet hole group. Each second gas inlet hole 321 is arranged to face the area between two adjacent first gas inlet hole groups, so as to ensure the gas flow blocking and attenuation effect of the first vacuum breaking mechanism 3. Optionally, in this embodiment, each second gas inlet hole 321 has a width of 1 mm to 40 mm along the second side direction, and the spacing between two adjacent second gas inlet holes 321 ranges from 1 mm to 40 mm. Optionally, in this embodiment, both the first gas inlet hole 311 and the second gas inlet hole 321 are straight holes. That is, the hole diameter of each first gas inlet hole 311 and each second gas inlet hole 321 is consistent along its penetration direction. In this embodiment, the hole diameter of each first gas inlet hole 311 ranges from 1 mm to 15 mm. In other embodiments, the first gas inlet hole 311 and the second gas inlet hole 321 may also be in the form of flared holes.

In this embodiment, the second vacuum breaking mechanism 4 is structurally similar to the first vacuum breaking mechanism 3 and is arranged symmetrically relative thereto. The exploded structure thereof may refer to that of the first vacuum breaking mechanism 3. The third gas inlet hole 411 is a circular hole, and the fourth gas inlet hole 421 is an elongated hole. By adopting such hole configurations, the blocking effect of the fourth gas inlet plate 42 on the gas flow flowing out of the third gas inlet hole 411 is improved, which ensures that the gas flow discharged through the fourth gas inlet hole 421 can generate transversely deflected flow and also makes the flow velocity of the gas flow discharged through each of the fourth gas inlet holes 421 more uniform. Optionally, in this embodiment, both the third gas inlet plate 41 and the fourth gas inlet plate 42 are in the form of rectangular plates. The extending direction of the first side of the fourth gas inlet plate 42 is defined as the third side direction, and the extending direction of the second side of the fourth gas inlet plate 42 is defined as the fourth side direction, wherein the first side and the second side are perpendicular to each other. The fourth gas inlet hole 421 extends along the third side direction, and the plurality of fourth gas inlet holes 421 are arranged at intervals along the fourth side direction. A plurality of the third gas inlet holes 411 are arranged in an array on the third gas inlet plate 41; moreover, a plurality of third gas inlet holes 411 spaced apart along the third side direction form one second gas inlet hole group. Each fourth gas inlet hole 421 is arranged to face the area between two adjacent second gas inlet hole groups, so as to ensure the gas flow blocking and attenuation effect of the second vacuum breaking mechanism 4. Optionally, in this embodiment, the width of each fourth gas inlet hole 421 along the fourth side direction ranges from 1 mm ~ 40 mm, and the spacing between every two adjacent fourth gas inlet holes 421 also ranges from 1 mm to 40 mm. Optionally, in this embodiment, both the third gas inlet holes 411 and the fourth gas inlet holes 421 are straight holes. That is, the hole diameter of each third gas inlet hole 411 and each fourth gas inlet hole 421 is consistent along its penetration direction. In this embodiment, the hole diameter of each third gas inlet hole 411 ranges from 1 mm to 15 mm. In other embodiments, the third gas inlet hole 411 and the fourth gas inlet hole 421 may also be in the form of flared holes.

As shown in FIG. 1 and FIG. 3, the first vacuum breaking mechanism 3 further includes a first mounting enclosure 33. The first mounting enclosure 33 is disposed on the chamber cover 2. Both the first gas inlet plate 31 and the second gas inlet plate 32 are connected to the first mounting enclosure 33. The first gas inlet plate 31, the first mounting enclosure 33, and the chamber cover 2 jointly define a first gas inlet space 36; the first gas inlet plate 31, the second gas inlet plate 32, and the first mounting enclosure 33 jointly define a second gas inlet space 37. The first gas inlet port 21, the first gas inlet space 36, and the second gas inlet space 37 are in sequential communication with one another. When the vacuum chamber is vacuum breaking via the first vacuum breaking mechanism 3, gas flow flowing through the first gas inlet 21 in the chamber cover 2 first flows into the first gas inlet space 36. After the gas flow undergoes preliminary deceleration and attenuation, the gas flow flows into the second gas inlet space 37 through the first gas inlet hole 311 in the first gas inlet plate 31. After being blocked by the second gas inlet plate 32, the gas flow is further attenuated and then flows into the interior of the vacuum chamber through the second gas inlet hole 321 in the second gas inlet plate 32, so as to further lower the flow velocity of the gas flow and reduce the impact of the gas flow on the inside of the vacuum chamber.

Optionally, in this embodiment, the vertical gap between the first gas inlet plate 31 and the chamber cover 2 ranges from 1 mm to 15 mm. By way of example, the vertical gap between the first gas inlet plate 31 and the chamber cover 2 may be 1 mm, 3 mm, 5 mm, 7 mm, 8 mm, 10 mm, 12 mm, 14 mm, or 15 mm. In addition, the vertical gap between the second gas inlet plate 32 and the first gas inlet plate 31 also ranges from 1 mm to 15 mm. By way of example, the vertical gap between the second gas inlet plate 32 and the first gas inlet plate 31 may be 1 mm, 3 mm, 5 mm, 7 mm, 8 mm, 10 mm, 12 mm, 14 mm, or 15 mm.

Optionally, the first mounting enclosure 33 and the second gas inlet plate 32 may be formed integrally, thereby facilitating the manufacturing of the entire first vacuum breaking mechanism 3. Optionally, in other embodiments, the first mounting enclosure 33 and the second gas inlet plate 32 may be two components connected detachably.

Optionally, as shown in FIG. 3, the first vacuum breaking mechanism 3 further comprises a plurality of first locking connectors 34, which are configured to detachably connect the first gas inlet plate 31 and the second gas inlet plate 32 to the first mounting enclosure 33. In some embodiments, the first locking connectors 34 may be bolts. Each bolt penetrates the first mounting enclosure 33 and is threadedly coupled to the first gas inlet plate 31. Such bolts feature reliable connection and low cost. In other embodiments, the first locking connectors 34 may be other types of connecting members such as screws.

In this embodiment, as shown in FIG. 1 and FIG. 5, the second vacuum breaking mechanism 4 further includes a second mounting enclosure 43. The second mounting enclosure 43 is disposed on the bottom wall 13. Both the third gas inlet plate 41 and the fourth gas inlet plate 42 are connected to the second mounting enclosure 43. The third gas inlet plate 41, the second mounting enclosure 43 and the bottom wall 13 jointly define a third gas inlet space 46; and the third gas inlet plate 41, the fourth gas inlet plate 42 and the second mounting enclosure 43 jointly define a fourth gas inlet space 47. The second gas inlet port 15, the third gas inlet space 46 and the fourth gas inlet space 47 are in sequential communication with one another. When the vacuum chamber is vacuum breaking via the second vacuum breaking mechanism 4, gas flow flowing via the second gas inlet port 15 on the bottom wall 13 first flows into the third gas inlet space 46. After the gas flow undergoes preliminary deceleration and attenuation, the gas flow flows into the fourth gas inlet space 47 through each third gas inlet hole 411 on the third gas inlet plate 41. After being blocked by the fourth gas inlet plate 42, the gas flow is further attenuated and then flows into the interior of the vacuum chamber through the fourth gas inlet holes 421 on the fourth gas inlet plate 42, so as to further lower the flow velocity of the gas flow and reduce the impact of the gas flow on the inside of the vacuum chamber.

Optionally, in this embodiment, the vertical gap between the third gas inlet plate 41 and the fourth gas inlet plate 42 ranges from 1 mm to 15 mm. By way of example, the vertical gap between the third gas inlet plate 41 and the fourth gas inlet plate 42 may be 1 mm, 3 mm, 5 mm, 7 mm, 8 mm, 10 mm, 12 mm, 14 mm, or 15 mm.

Optionally, the second mounting enclosure 43 and the fourth gas inlet plate 42 may be formed integrally, thereby facilitating the manufacturing of the entire second vacuum breaking mechanism 4. Optionally, in other embodiments, the second mounting enclosure 43 and the fourth gas inlet plate 42 may be two components connected detachably.

Optionally, as shown in FIG. 5, the second vacuum breaking mechanism 4 further comprises a plurality of second locking connectors 48, which are configured to detachably connect the third gas inlet plate 41 and the fourth gas inlet plate 42 to the second mounting enclosure 43. In some embodiments, the second locking connectors 48 may be bolts. Each bolt penetrates the second mounting enclosure 43 and is threadedly coupled to the third gas inlet plate 41. Such bolts feature reliable connection and low cost. In other embodiments, the second locking connectors 48 may be other types of connecting members such as screws.

In addition, as shown in FIG. 1, the vacuum chamber provided in this embodiment further comprises a vacuum pumping mechanism 5. The vacuum pumping mechanism 5 is configured to evacuate gas from the inside of the chamber body 1, so as to convert the internal environment of the vacuum chamber from a standard atmospheric state to a vacuum state. The vacuum pumping mechanism 5 may adopt any specific structure of vacuum pumping mechanisms disclosed in the related art.

Optionally, a vacuum pumping port 11 is formed in the bottom wall 13. The vacuum pumping mechanism 5 is in communication with the vacuum pumping port 11. The vacuum chamber comprises a plurality of second vacuum breaking mechanisms 4 arranged at intervals. A first vacuum pumping channel 12 is defined between every two adjacent second vacuum breaking mechanisms 4, and the first vacuum pumping channel 12 is in communication with the vacuum pumping port 11. When the vacuum pumping mechanism 5 extracts gas from the interior of the chamber body 1, gas inside the chamber body 1 flows to the vacuum pumping port 11 through the first vacuum pumping channels 12 defined between every two adjacent second vacuum breaking mechanisms 4 and is then extracted by the vacuum pumping mechanism 5. In this way, both gas and dust inside the chamber body 1 can quickly converge at the vacuum pumping port 11, so as to improve the evacuation speed.

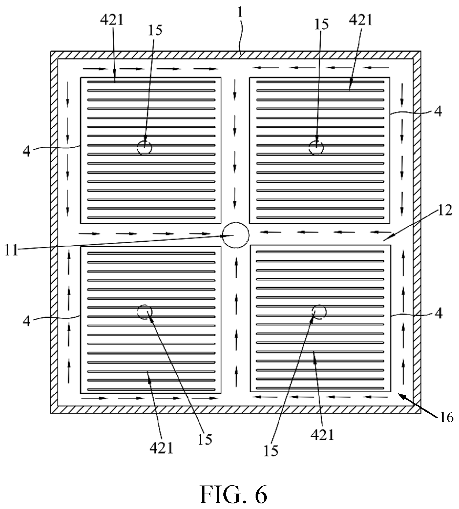

Optionally, in this embodiment, as shown in FIG. 6, the vacuum chamber comprises four second vacuum breaking mechanisms 4 arranged at intervals. A cross-shaped first vacuum pumping channel 12 is defined among the four second vacuum breaking mechanisms 4. A second vacuum pumping channel 16 in communication with the first vacuum pumping channel 12 is defined between the outer peripheral wall of each second vacuum breaking mechanism 4 and the side wall 14 of the chamber body 1. The central intersection area of the first vacuum pumping channel 12 is directly aligned with the vacuum pumping port 11 located at the center of the bottom wall 13. When the vacuum pumping mechanism 5 evacuates the interior of the chamber body 1, gas flow inside the chamber body 1 drives dust downward through the second vacuum pumping channels 16 arranged around the the chamber body 1 and enter the first vacuum pumping channel 12. Subsequently, the gas flow and dust rapidly converge toward the central region via the cross-shaped first vacuum pumping channel 12 and are finally discharged through the vacuum pumping port 11. This structure prevents disordered flowing of gas flow and dust inside the chamber body 1, effectively improves the extraction efficiency and effect of gas flow and dust, and avoids dust contamination of the chamber body 1.

Optionally, the height of the cross-shaped first vacuum pumping channel 12 ranges from 30 mm to 200 mm. Optionally, the height of the cross-shaped first vacuum pumping channel 12 may be 30 mm, 35 mm, 40 mm, 45 mm, 50 mm, 60 mm, 70 mm, 80 mm, 90 mm, 100 mm, 150 mm or 200 mm. Adoption of the foregoing height values enables the chamber body 1 to be rapidly evacuated to a vacuum state, thereby improving the vacuum pumping speed.

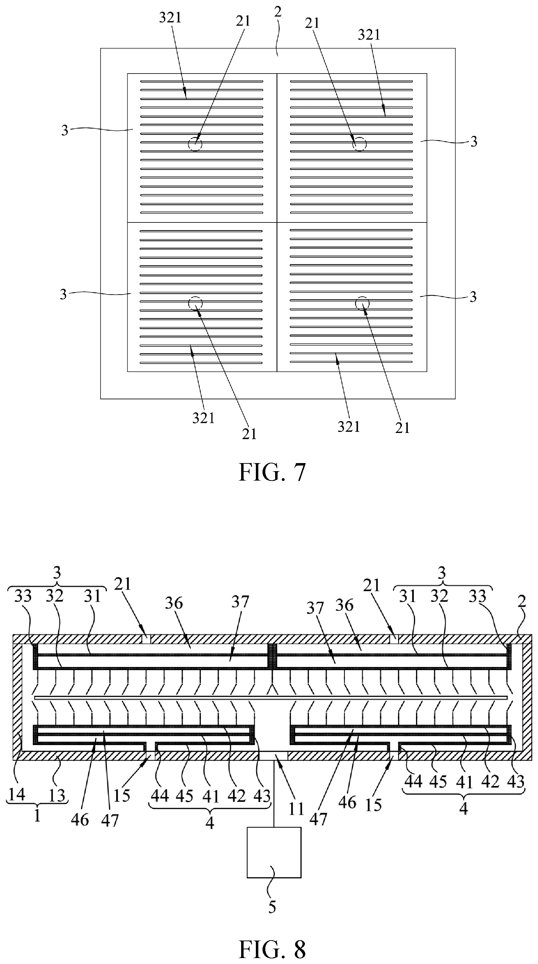

Optionally, in this embodiment as shown in FIG. 7, four first vacuum breaking mechanisms 3 are provided and arranged in a rectangular layout. Optionally, in other embodiments, the number of the first vacuum breaking mechanism 3 may be one. In this case, a plurality of first gas inlets 21 may be formed in the chamber cover 2, all of which are in communication with the first vacuum breaking mechanism 3.

### Embodiment 2

The vacuum chamber provided in this embodiment is substantially the same as that provided in Embodiment 1. The differences between the two vacuum chambers are as follows:
As shown in FIGS. 8 to 10, the second vacuum breaking mechanism 4 further comprises a second mounting enclosure 43, a gas inlet passage 44, and a venting back plate 45. One end of the gas inlet channel 44 is connected to the second gas inlet 15, and the other end is connected to the venting back plate 45. The third gas inlet plate 41, the fourth gas inlet plate 42, and the venting back plate 45 are all connected to the second mounting enclosure 43. The third gas inlet plate 41, the second mounting enclosure 43, and the venting back plate 45 jointly define a third gas inlet space 46; the third gas inlet plate 41, the fourth gas inlet plate 42, and the second mounting enclosure 43 jointly define a fourth gas inlet space 47. The second gas inlet 15, the gas inlet passage 44, the third gas inlet space 46, and the fourth gas inlet space 47 are in sequential communication with one another. When the vacuum chamber is vacuum breaking via the second vacuum breaking mechanism 4, gas flow flowing through the second gas inlet 15 in the bottom wall 13 first flows into the third gas inlet space 46 through the gas inlet passage 44. After preliminary deceleration and attenuation, the gas flow then flows into the fourth gas inlet space 47 through the respective third gas inlet holes 411 in the third gas inlet plate 41. After being blocked by the fourth gas inlet plate 42, the gas flow is further attenuated, and then flows into the interior of the vacuum chamber via the fourth gas inlet holes 421 in the fourth gas inlet plate 42. This structure further reduces the flow velocity of the gas flow and alleviates the impact of gas flow on the inner part of the vacuum chamber.

In this embodiment, as illustrated in FIG. 8, the second vacuum breaking mechanisms 4 are arranged at intervals, so that a first vacuum pumping channel 12 is defined between two adjacent second vacuum breaking mechanisms 4.

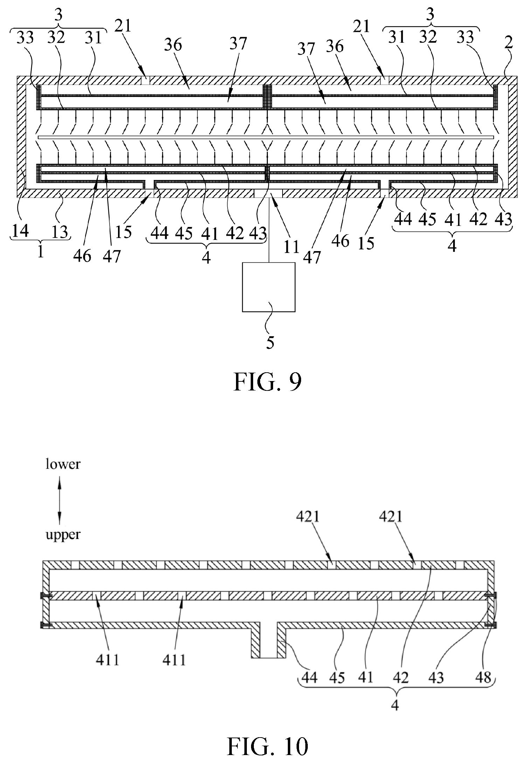

Optionally, in this embodiment, as illustrated in FIG. 9, the second vacuum breaking mechanisms 4 may be directly connected to one another, so that no first vacuum pumping channel 12 is defined therebetween. The layout of the second vacuum breaking mechanisms 4 is the same as that of the plurality of first vacuum breaking mechanisms 3 arranged on the chamber cover 2. Optionally, in the present embodiment, only one second vacuum breaking mechanism 4 may be provided.

Optionally, in this embodiment, as shown in FIG. 10, the second mounting enclosure 43 and the fourth gas inlet plate 42 are formed integrally. The third gas inlet plate 41 and the venting back plate 45 are both detachably connected to the second mounting enclosure 43 through the second locking connectors 48.

### Embodiment 3

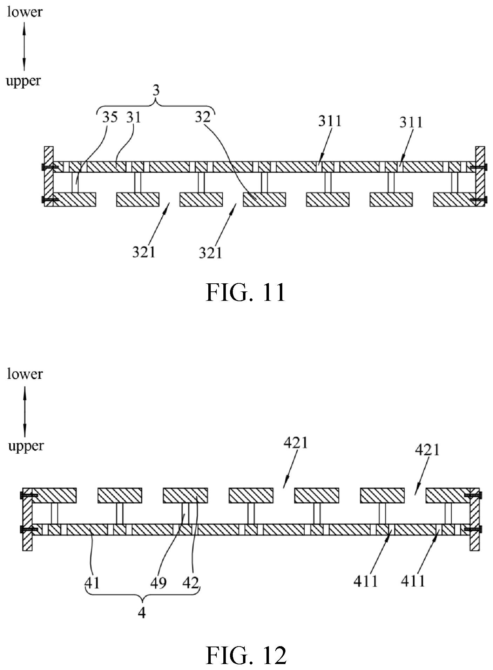

The vacuum chamber provided in this embodiment is substantially the same as that provided in Embodiment 1. The differences between the two vacuum chambers are as follows:
As shown in FIG. 11, the first vacuum breaking mechanism 3 further comprises first support connecting members 35, which are supported and connected between the first gas inlet plate 31 and the second gas inlet plate 32. Optionally, the second gas inlet plate 32 is composed of a plurality of splicing plates arranged at intervals, and the gap between every two adjacent splicing plates forms a second gas inlet hole 321. A first support connecting member 35 is disposed between each splicing plate and the first gas inlet plate 31, and the first support connecting member 35 may be a support stud.

Similarly, as shown in FIG. 12, the second vacuum breaking mechanism 4 further comprises second support connecting members 49, which are supported and connected between the third gas inlet plate 41 and the fourth gas inlet plate 42. Optionally, the fourth gas inlet plate 42 is composed of a plurality of splicing plates arranged at intervals, and the gap between every two adjacent spliced plates forms a fourth gas inlet hole 421. A second support connecting member 49 is provided between each splicing plate and the third gas inlet plate 41, and the second support connecting member 49 may be a support stud.

## Claims

1. A vacuum chamber, comprising:
a chamber body (1);
a chamber cover (2) disposed on the chamber body (1), the chamber cover having a first gas inlet (21) formed through;
wherein the vacuum chamber further comprises at least one selected from at least one first vacuum breaking mechanism (3) and at least one second vacuum breaking mechanism (4);
wherein the first vacuum breaking mechanism (3), when present, is disposed on the chamber cover (2) and in communication with the first gas inlet (21); the first vacuum breaking mechanism (3) comprises a first gas inlet plate (31) and a second gas inlet plate (32). The first gas inlet plate (31) is formed with a plurality of spaced apart first gas inlet holes (311), the second gas inlet plate (32) is formed with a plurality of spaced apart second gas inlet holes (321), and the second gas inlet holes (321) are staggered relative to the first gas inlet holes (311) horizontally;
and wherein the second vacuum breaking mechanism (4), when present, is disposed on an inner side of a bottom wall (13) of the chamber body (1) and in communication with a second gas inlet (15) formed in the chamber body (1); the second vacuum breaking mechanism (4) comprises a third gas inlet plate (41) and a fourth gas inlet plate (42); The third gas inlet plate (41) is formed with a plurality of spaced apart third gas inlet holes (411), the fourth gas inlet plate (42) is formed with a plurality of spaced apart fourth gas inlet holes (421), and the fourth gas inlet holes (421) are staggered relative to the third gas inlet holes (411) horizontally.

2. The vacuum chamber according to claim 1, wherein the first vacuum breaking mechanism (3) further comprises:
a first mounting enclosure (33) disposed on the chamber cover (2), wherein both the first gas inlet plate (31) and the second gas inlet plate (32) are connected to the first mounting enclosure (33); the first gas inlet plate (31), the first mounting enclosure (33), and the chamber cover (2) jointly define a first gas inlet space (36); the first gas inlet plate (31), the second gas inlet plate (32), and the first mounting enclosure (33) jointly define a second gas inlet space (37); and the first gas inlet (21), the first gas inlet space (36), and the second gas inlet space (37) are sequentially in communication.

3. The vacuum chamber according to claim 1, wherein the second vacuum breaking mechanism (4) further comprises:
A second mounting enclosure (43) disposed on the bottom wall (13), wherein both the third gas inlet plate (41) and the fourth gas inlet plate (42) are connected to the second mounting enclosure (43); the third gas inlet plate (41), the second mounting enclosure (43), and the bottom wall (13) jointly define a third gas inlet space (46); the third gas inlet plate (41), the fourth gas inlet plate (42), and the second mounting enclosure (43) jointly define a fourth gas inlet space (47); and the second gas inlet (15), the third gas inlet space (46), and the fourth gas inlet space (47) are sequentially in communication.

4. The vacuum chamber according to claim 1, wherein the second vacuum breaking mechanism (4) further comprises a second mounting enclosure (43), a gas inlet passage (44), and a venting back plate (45); a first end of the gas inlet passage (44) is connected to the second gas inlet (15), a second end of the gas inlet passage (44) is connected to the venting back plate (45), and the third gas inlet plate (41), the fourth gas inlet plate (42), and the venting back plate (45) are all connected to the second mounting enclosure (43); the third gas inlet plate (41), the second mounting enclosure (43), and the venting back plate (45) jointly define a third gas inlet space (46); the third gas inlet plate (41), the fourth gas inlet plate (42), and the second mounting enclosure (43) jointly define a fourth gas inlet space (47); and the second gas inlet (15), the gas inlet passage (44), the third gas inlet space (46), and the fourth gas inlet space (47) are sequentially in communication.

5. The vacuum chamber according to claim 3 or 4, wherein a vacuum pumping port (11) is formed in the bottom wall (13); the vacuum chamber comprises a plurality of second vacuum breaking mechanisms (4) spaced apart from one another; a first vacuum pumping channel (12) is defined between two adjacent second vacuum breaking mechanisms (4); and the first vacuum pumping channel (12) is in communication with the vacuum pumping port (11).

6. The vacuum chamber according to claim 5, wherein the plurality of second vacuum breaking mechanisms (4) are four second vacuum breaking mechanisms (4) spaced apart from one another; a cross-shaped first vacuum pumping channel (12) is defined among the four second vacuum breaking mechanisms (4); a second vacuum pumping channel (16) in communication with the first vacuum pumping channel (12) is defined between an outer peripheral wall of each second vacuum breaking mechanism (4) and the side wall (14) of the chamber body (1); and a central intersection region of the first vacuum pumping channel (12) is directly aligned with the vacuum pumping port (11) located at the center of the bottom wall (13).

7. The vacuum chamber according to claim 6, wherein the height of the cross-shaped first vacuum pumping channel (12) ranges from 30 mm to 200 mm.

8. The vacuum chamber according to claim 2, wherein the first vacuum breaking mechanism (3) further comprises first locking connectors (34); and the first locking connectors (34) are configured to detachably connect the first gas inlet plate (31) and the second gas inlet plate (32) to the first mounting enclosure (33).

9. The vacuum chamber according to claim 2, wherein the first mounting enclosure (33) and the second gas inlet plate (32) are formed integrally.

10. The vacuum chamber according to claim 3 or 4, wherein the second vacuum breaking mechanism (4) further comprises second locking connectors (48); and the second locking connectors (48) are configured to detachably connect the third gas inlet plate (41) and the fourth gas inlet plate (42) to the second mounting enclosure (43).

11. The vacuum chamber according to claim 3 or 4, wherein the second mounting enclosure (43) and the fourth gas inlet plate (42) are formed integrally.

12. The vacuum chamber according to claim 1, wherein the first vacuum breaking mechanism (3) further comprises first support connecting members (35) extending between the first gas inlet plate (31) and the second gas inlet plate (32) to provide support.

13. The vacuum chamber according to claim 1 or 12, wherein the second vacuum breaking mechanism (4) further comprises second support connecting members (49) extending between the third gas inlet plate (41) and the fourth gas inlet plate (42) to provide support.

14. The vacuum chamber according to any one of claims 1 to 4, wherein the first gas inlet holes (311) and the third gas inlet holes (411) are straight holes or flared holes; and the second gas inlet holes (321) and the fourth gas inlet holes (421) are straight holes or flared holes.

15. The vacuum chamber according to any one of claims 1 to 4, wherein the first gas inlet holes (311) and the third gas inlet holes (411) are circular holes, and the second gas inlet holes (321) and the fourth gas inlet holes (421) are elongated holes.

16. The vacuum chamber according to any one of claims 1 to 4, wherein the number of the first vacuum breaking mechanisms (3) is one and the number of the second vacuum breaking mechanisms (4) is four, or the number of the first vacuum breaking mechanisms (3) is four and the number of the second vacuum breaking mechanisms (4) is four.
